# EUROPEAN PATENT SPECIFICATION

(11) **EP 3 282 040 B1**
(45) Date of publication and mention of the grant of the patent: **18.12.2019**
(21) Application number: 16771562.2
(22) Date of filing: 08.01.2016
(51) Int. Cl.: C23C 2/06, C23C 2/40, C23C 2/28, C23C 28/00, H01L 23/373, F28F 19/06

(54) **USE OF A PLATED STEEL SHEET AS HEAT-ABSORBING AND RADIATING STEEL SHEET**
VERWENDUNG EINES PLATTIERTEN STAHLBLECHS ALS WÄRMEABSORBIERENDES UND -ABSTRAHLENDES STAHLBLECH
UTILISATION D'UNE TÔLE D'ACIER REVÊTUE COMME TÔLE D'ACIER ABSORBANT ET RAYONNANT LA CHALEUR

(30) Priority: 31.03.2015 JP 2015071372
(43) Date of publication of application: 14.02.2018
(73) Proprietor: NIPPON STEEL NISSHIN CO., LTD., Chiyoda-ku Tokyo 100-8366 (JP)
(72) Inventor: UENO, Shin, Tokyo 100-8366 (JP); NAKANO, Tadashi, Tokyo 100-8366 (JP); YAMAMOTO, Masaya, Tokyo 100-8366 (JP)
(74) Representative: Epping - Hermann - Fischer
(86) International application number: PCT/JP2016/000072
(87) International publication number: WO 2016/157665

(56) References cited:
- WO-A1-2013/160973
- JP-A- 2011 214 145
- JP-A- 2012 052 157
- JP-A- 2013 095 960
- JP-A- 2014 129 589

## Description

### Technical Field

The present invention relates to a heat absorbing/radiating (heat absorbing and/or radiating) steel sheet and a heat absorbing/radiating member, more specifically, to a heat absorbing/radiating steel sheet which has excellent heat absorbing/radiating properties and processability, and is suitable as a material for a housing of a heat source device, such as an electronic or electrical component, and to a heat absorbing/radiating member composed of the heat absorbing/radiating steel sheet.

### Background Art

In recent years, the internal temperature of a housing (i.e., case) that houses an electronic or electrical component tends to become higher as the electronic or electrical component becomes smaller and has higher functions. A higher internal temperature causes a failure or malfunction of the electronic or electrical component, and leads to a shortened product life.

As methods for lowering the internal temperature of the component housing, proposed are, for example, forced air cooling using a cooling fan, heat radiation promoting using a cooling fin, and a method in which a heat radiating member, such as a heat pipe, is attached to the electronic or electrical component. However, for these methods, it is necessary to attach a cooling member to the housing. Attaching such a cooling member or an electronic or electrical component having such a cooling member becomes complex, and the cost relating to the electronic or electrical component may increase. Demand for downsizing the electronic or electrical component may not be satisfied, either.

A method has been studied in which the housing is produced from a material having excellent heat absorbing/radiating properties to absorb heat at the inner surface of the housing and radiate the heat from the outer surface thereof, thereby suppressing increase of the internal temperature of the housing. As the materials having excellent heat absorbing/radiating properties, known are, for example, a coated steel sheet including a steel sheet and a coating disposed on the surface thereof, which contains, e.g., a pigment or resin having excellent heat absorbing/radiating properties (see, for example, PTLs 1 and 2).

### Citation List

### Patent Literature

PTL 1
   Japanese Patent Application Laid-Open No. 2004-216376
PTL 2
   Japanese Patent Application Laid-Open No. 2006-95709

WO 2013/160973 A, in the name of Nisshin Steel Co., Ltd., discloses a black-plated steel sheet comprising a hot-dip Al and Mg-containing Zn-plated layer which comprises 1.0 to 22.0 mass% of Al and 1.3 to 10.0 mass% of Mg, with a black oxide of Zn distributed in a lamellar form in the hot-dip Al and Mg-containing Zn-plated layer.

### Summary of Invention

### Technical Problem

The above coated steel sheet is produced by applying a coating material containing an additive, resin and/or the like to have a predetermined emissivity, and baking the coating material. Such a method tends to need high production costs. There is also a concern that the coating may be peeled off from the coated steel sheet to expose a base (for example, a plating layer or base metal of the steel sheet) upon processing, and the heat absorbing/radiating properties of the exposed portion may decrease. Environmental concerns may also arise from using the above coating material that requires a high amount of a volatile organic compound (VOC).

Another method for producing a housing from a material having excellent heat absorbing/radiating properties can be considered, in which a steel sheet is processed followed by applying a coating material having excellent heat absorbing/radiating properties. However, uniformly applying a coating material on a processed product that was formed into a complex shape by processing the steel sheet is difficult and expensive, and further; the impact of VOC on the environment is more likely to become high compared to the above described coated steel sheet.

An object of the present invention is to provide a heat absorbing/radiating steel sheet which does not suffer reduction of heat absorbing/radiating properties caused by processing, contains substantially no organic compound, and has excellent heat absorbing/radiating properties and processability, and a novel heat absorbing/radiating member which has excellent heat absorbing/radiating properties.

### Solution to Problem

The present inventors have found that both satisfactory heat absorbing/radiating properties and processability can be achieved by distributing, in a lamellar form, either one or both of oxide(s) and hydroxide(s) of Zn, Al and/or Mg, each having lattice defects, in a hot-dip plating layer of a hot-dip Zn-Al-Mg alloy plated steel sheet formed by hot-dip plating with molten metal containing zinc (Zn), aluminum (Al) and magnesium (Mg), and conducted further studies to complete the present invention.

The present invention provides the use of a plated steel as a heat absorbing/radiating steel sheet including a steel sheet and a hot-dip plating layer disposed on a surface of the steel sheet, the heat absorbing/radiating steel sheet having an emissivity of 0.4 or more, in which the hot-dip plating layer contains zinc, 1.0 to 22.0 mass% of aluminum, 1.3 to 10.0 mass% of magnesium, and all oxides and hydroxides of all zinc, aluminum and magnesium, the oxides and the hydroxides having a lattice defect and being distributed in a lamellar form. An area of a portion of the oxides and hydroxides in a field of view with 20 mm length in a cross section of the plated steel is 0.01 mm² or more, and a ratio of an area of a portion of the oxides and the hydroxides to an area of the hot-dip plating layer is 95 % or less.

Also disclosed is a heat absorbing/radiating member composed of the heat absorbing/radiating steel sheet.

### Advantageous Effects of Invention

The present invention uses a heat absorbing/radiating steel sheet which does not suffer reduction of heat absorbing/radiating properties caused by processing, contains substantially no organic compound, and has excellent heat absorbing/radiating properties and processability. The heat absorbing/radiating steel sheet can be provided at low costs, and have excellent heat absorbing/radiating properties even when processed into a shape which is difficult to be processed (for example, a complex shape or a shape formed by detailed processing). The present invention uses thus a heat absorbing/radiating member which has excellent heat absorbing/radiating properties. As a result, the heat absorbing/radiating member can be provided, which has higher freedom in its product shape, and enables further downsizing of a conventional product having heat absorbing/radiating properties.

### Brief Description of Drawings

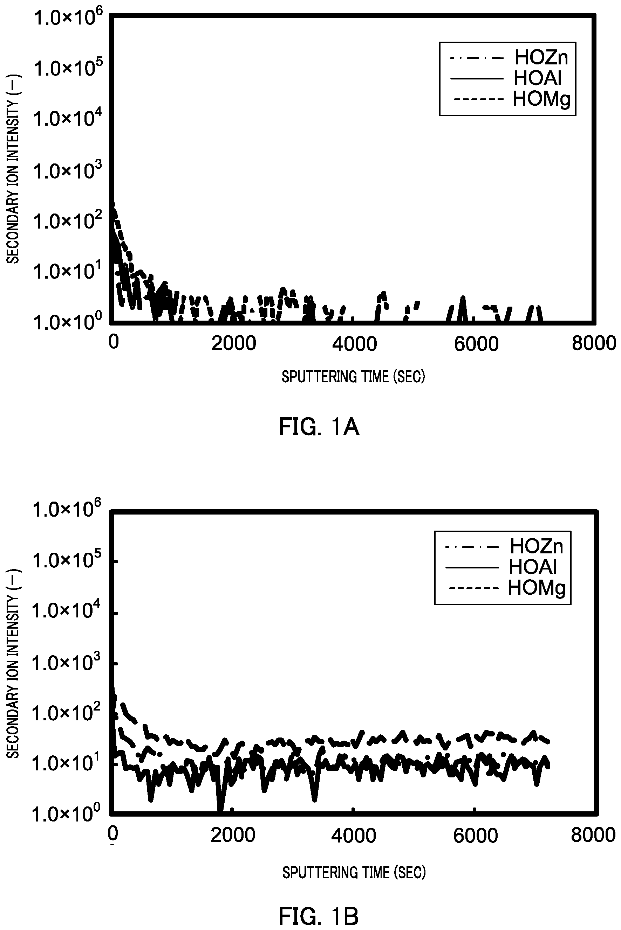

FIG. 1A illustrates measurement results by TOF-SIMS for hydroxides in a hot-dip plating layer in an example of hot-dip plated steel sheets in the present invention, and FIG. 1B illustrates measurement results by TOF-SIMS for hydroxides in a hot-dip plating layer in an example of heat absorbing/radiating steel sheets used according to the present invention;

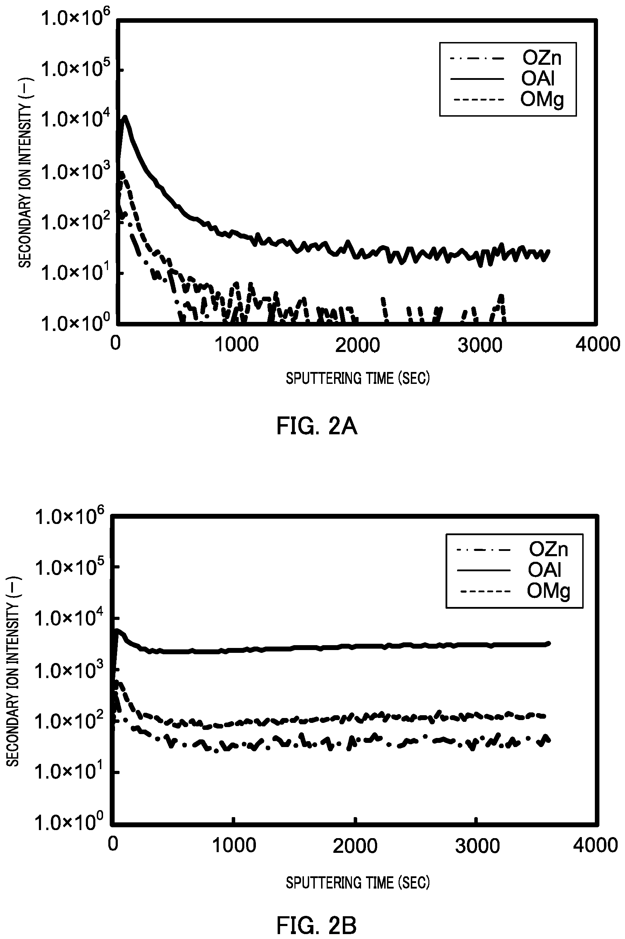

FIG. 2A illustrates measurement results by TOF-SIMS for oxides in the hot-dip plating layer in the example of hot-dip plated steel sheets used in the present invention, and FIG. 2B illustrates measurement results by TOF-SIMS for oxides in the hot-dip plating layer in the example of heat absorbing/radiating steel sheets used according to the present invention;

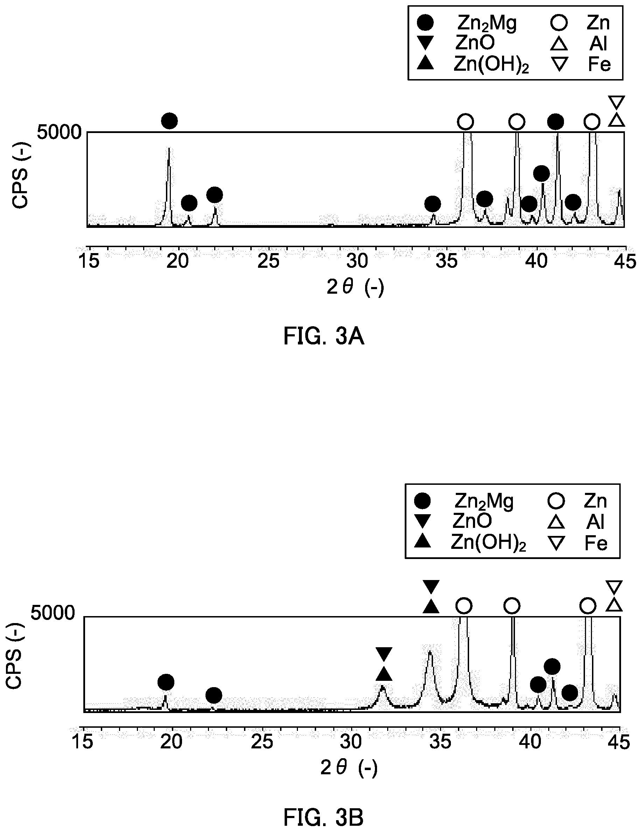

FIG. 3A illustrates an X-ray diffraction chart of the hot-dip plating layer in the example of hot-dip plated steel sheets used in the present invention, and FIG. 3B illustrates an X-ray diffraction chart of the hot-dip plating layer in the example of heat absorbing/radiating steel sheets used according to the present invention;

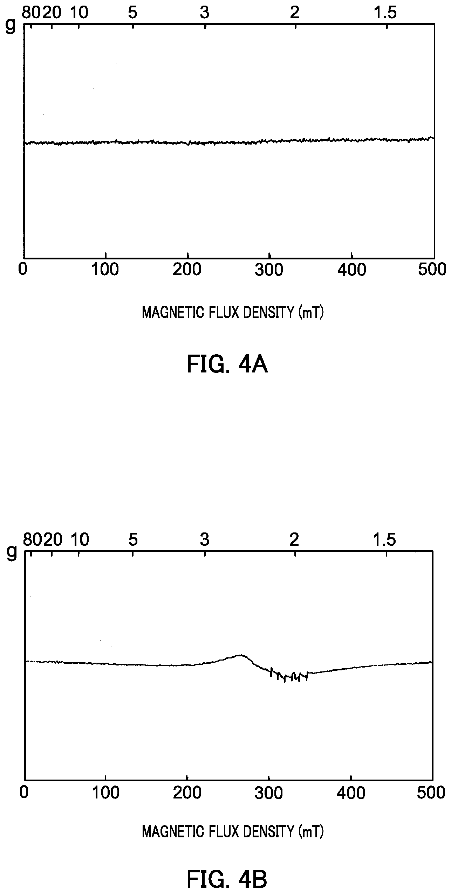

FIG. 4A illustrates an ESR spectrum of the hot-dip plating layer in the example of hot-dip plated steel sheets used in the present invention, and FIG. 4B illustrates an ESR spectrum of the hot-dip plating layer in the example of heat absorbing/radiating steel sheets used according to the present invention;

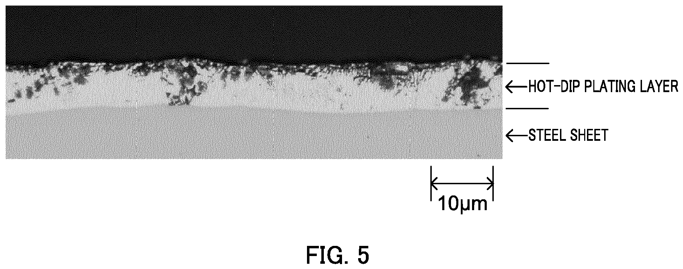

FIG. 5 is an optical microscope photograph of a cross-section in the example of heat absorbing/radiating steel sheets used in the present invention; and

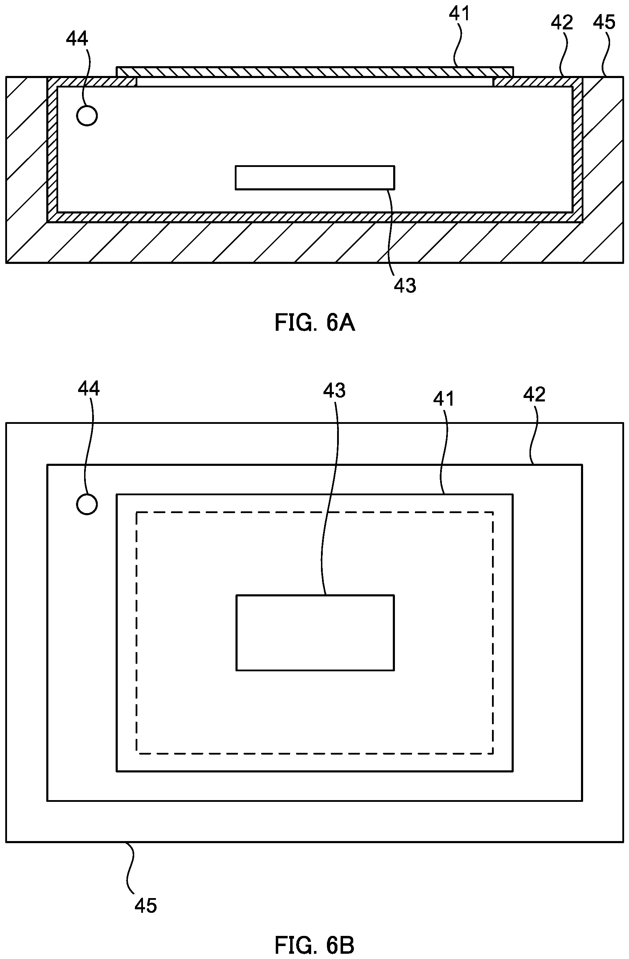

FIG. 6A is a fragmentary sectional view schematically illustrating a configuration of an apparatus used for measurement of heat absorbing/radiating properties of a heat absorbing/radiating steel sheet used in of the present invention, and FIG. 6B is a plan view schematically illustrating the configuration of the apparatus.

### Description of Embodiments

"Radiation (emission)" is one of the ways how heat is transferred. This is a phenomenon in which heat propagates as electromagnetic waves. It is known that when heat enters an object, the heat is partly reflected, partly transmitted, and partly absorbed. Heat entered a steel sheet is hardly transmitted therethrough, and thus the heat entered the steel sheet is partly reflected, and the rest is absorbed.

"Having excellent heat absorbing/radiating properties" can be said as "absorbing heat easily," and also as "absorbing electromagnetic waves easily." An oxide and hydroxide each having lattice defects have an energy level at a band gap or lower, and thus easily absorb and emit electromagnetic waves. This means the oxide and hydroxide can easily absorb and emit heat.

However, such oxides and hydroxides are hard and brittle in general. When a layer of the oxide or hydroxide is formed on the surface of a steel sheet, the formed layer is easily peeled off when processed. Even when the oxide or hydroxide layer is formed on a steel sheet where pits are formed on the surface thereof by shot blasting or etching, the layer is still easily dropped off when processed thereafter.

The present inventors have then considered subjecting a plated steel sheet to certain treatment to allow a plating layer of the steel sheet to have an oxide or hydroxide each having lattice defects. The inventors have found, as a result, that a method in which treatment of bringing a hot-dip Zn plated steel sheet into contact with water vapor can convert a part of metal in a hot-dip plating layer of the steel sheet to an oxide or hydroxide each having lattice defects. Subjecting a normal hot-dip Zn plated steel sheet or an electrogalvanized steel sheet to the above treatment can form a layer of an oxide or hydroxide each having lattice defects.

However, when the plating layer to be subjected to the treatment is uniform, the oxide or hydroxide layer is formed only on the surface of the plated steel sheet. The layer formed on the surface of such a plated steel sheet is still easily dropped off when processed. The inventors have found with further studies that subjecting a hot-dip Zn-Al-Mg alloy plated steel sheet to the above water vapor treatment results in the plated steel sheet having satisfactory processability without an oxide or hydroxide portion being peeled off even after processing.

Hereinafter, embodiments of the invention will be described. A heat absorbing/radiating steel sheet used according to the present embodiment includes a steel sheet and a hot-dip plating layer.

### [Steel Sheet]

Various steel sheets can be used as the steel sheet. Examples of the steel sheets include low-carbon steel, medium-carbon steel, high-carbon steel, alloy steel, high-strength steel and stainless steel sheets. For obtaining satisfactory press formability, the steel sheet is preferably a steel sheet for deep drawing, and examples thereof include low-carbon Ti-alloyed steel and low-carbon Nb-alloyed steel sheets. The steel sheet may be subjected to electroplating prior to the hot-dip plating for, for example, improving a plating property of the steel sheet. Examples of the electroplating include plating with Ni and Fe.

### [Hot-Dip Plating Layer]

The hot-dip plating layer is disposed on one or both of the surfaces of the steel sheet. The hot-dip plating layer contains Zn, Al and Mg. The Al content in the hot-dip plating layer is 1.0 to 22.0 mass%. The Mg content in the hot-dip plating layer is 1.3 to 10.0 mass%. The Zn content in the hot-dip plating layer may be the balance, and is, for example, 68 to 97.7 mass%.

When the content of Al or Mg is lower than the lower limit of the above range, the heat absorbing/radiating steel sheet cannot have satisfactory corrosion resistance in some cases. On the other hand, when the content of Al or Mg is higher than the upper limit of the above range, oxides called dross are generated in a large amount on the surface of a plating bath (molten metal) during the production of the hot-dip plated steel sheet, and the appearance of the heat absorbing/radiating steel sheet may not become satisfactory.

The hot-dip plating layer has eutectic structures in a lamellar form. The hot-dip plating layer having the eutectic structures in a lamellar form can prevent an oxide or hydroxide portion described below from being peeled off after processing of the heat absorbing/radiating steel sheet. The hot-dip plating layer typically has Al-Zn-Zn₂Mg ternary eutectic structures in a lamellar form. The hot-dip plating layer may have another eutectic structure in a lamellar form in a range where the peeling off of the oxide or hydroxide portion is prevented, and may contain, for example, Al-Zn or Zn-Zn₂Mg binary eutectic structures, or Zn₁₁Mg₂ in place of Zn₂Mg. The Zn₁₁Mg₂ phase can be formed under a certain conditions, such as a certain cooling rate of molten metal during the production of the hot-dip plating layer.

The hot-dip plating layer may further contain other metals in addition to Zn, Al and Mg, or inorganic components, in a range where the effect of the present embodiment is obtained. For example, the hot-dip plating layer may further contain 2.0 mass% or less of Si, 0.1 mass% or less of Ti, and/or 0.045 mass% or less of B. During the production of the hot-dip plating layer, the steel sheet is dipped in the molten metal and passed therethrough, and thus, a metal component in the steel sheet may typically be mixed into the hot-dip plating layer. Therefore, the hot-dip plating layer may further contain about 2.0 mass% or less of Fe.

The thickness of the hot-dip plating layer can be set in a range where the effect of the present embodiment is obtained, and is preferably, for example, 3 to 100 µm. When the thickness of the hot-dip plating layer is less than 3 µm, handling of the hot-dip plated steel sheet may inflict thereto a scratch that reaches the steel sheet, thereby reducing corrosion resistance. On the other hand, when the thickness of the hot-dip plating layer is more than 100 µm, the hot-dip plating layer is more likely to be peeled off from the steel sheet at the processed portion of the heat absorbing/radiating steel sheet since the ductility differs between the hot-dip plating layer and the steel sheet during compression. From the view point of preventing the reduction of corrosion resistance or peeling off of the hot-dip plating layer, the thickness of the hot-dip plating layer is more preferably 3 to 50 µm, and even more preferably 3 to 30 µm.

### [Oxide and Hydroxide each having Lattice Defects]

The hot-dip plating layer contains oxides and hydroxides each having lattice defects. The oxides and hydroxides are distributed in the hot-dip plating layer in a lamellar form. The term "in the hot-dip plating layer" herein refers to both the surface and inside of the hot-dip plating layer.

Bringing the hot-dip plated steel sheet into contact with water vapor generates both of the oxides and hydroxides which have lattice defects.

The oxides and hydroxides are all of Zn, Al and Mg, and can be identified by time-of-flight secondary ion mass spectrometry (TOF-SIMS) or X-ray photoelectron spectroscopy (ESCA or XPS). Since the oxides and hydroxides are a reaction product of a metal component in the hot-dip plating layer and water vapor, it is considered that the hot-dip plating layer contains both the oxides and hydroxides. Metal ions of the oxides and hydroxides are derived from a metal component in the hot-dip plating layer. The hot-dip plating layer contains both oxides and hydroxides of Zn, Al and Mg.

Examples of TOF-SIMS analysis results are shown in FIGS. 1A to 2B. FIG. 1A illustrates measurement results by TOF-SIMS for hydroxides in a hot-dip plating layer in hot-dip plated steel sheet 3 (hot-dip plated steel sheet before water vapor treatment) in Examples, and FIG. 1B illustrates measurement results by TOF-SIMS for hydroxides in a hot-dip plating layer in heat absorbing/radiating steel sheet 3 (hot-dip plated steel sheet after water vapor treatment) in the Examples. FIG. 2A illustrates measurement results by TOF-SIMS for oxides in the hot-dip plating layer in hot-dip plated steel sheet 3 (hot-dip plated steel sheet before water vapor treatment) in the Examples, and FIG. 2B illustrates measurement results by TOF-SIMS for oxides in the hot-dip plating layer in heat absorbing/radiating steel sheet 3 (hot-dip plated steel sheet after water vapor treatment) in the Examples. In FIGS. 1A and 1B, the dashed line, black solid line and black broken line represent HOZn, HOAl and HOMg, respectively. In FIGS. 2A and 2B, similarly, the dashed line, black solid line and black broken line represent OZn, OAl and OMg, respectively. As the measurement conditions, Ga⁺ is used as the primary ion species, the primary accelerating voltage is 15 kV, and the primary ion current is 0.6 nA. The raster area is 20 µm × 20 µm, and the measuring range is 0.5 to 2,000 m/z. In FIGS. 1A to 2B, the term "secondary ion intensity" refers to the number of secondary ions detected in 30 seconds, and the term "sputtering time" refers to the period of sputtering, and means the depth of the measured portion.

In both plated steel sheet 3 and heat absorbing/radiating steel sheet 3, the surface and the vicinity thereof (also referred to as "surface layer") of the hot-dip plating layer are oxidized by the atmosphere, and thus, secondary ions derived from both oxides and hydroxides are detected. However, in the hot-dip plating layer before the water vapor treatment, no secondary ion is detected in the inside of the hot-dip plating layer (also referred to as "bottom layer"), which resides inside compared to the surface layer. That is, the bottom layer of the hot-dip plating layer has no oxide and hydroxide, and is in a metal state (see, FIGS. 1A and 2A). However, in FIG. 2A, OAl is detected also in the bottom layer. It can be considered that Al is a metal with high ionization efficiency compared to Zn and Mg, and thus has high intensity also in the bottom layer. From the facts that the bottom layer substantially has no OZn and OMg, and intensity of OAl in FIG. 2A is satisfactorily lower than those in FIG. 2B, the present inventors consider that the detection of OAl in the bottom layer is caused by a measurement error or the like, and does not indicate the presence of Al oxides.

On the other hand, in the plating layer after the water vapor treatment, secondary ions of both oxides and hydroxides are detected also in the bottom layer. As described above, OAl exhibits obviously high intensity in FIG. 2B than in FIG. 2A, and thus, the presence of the Al oxide can be confirmed. For oxides, the number of secondary ions derived from Al oxide is large, and for hydroxides, the number of secondary ions derived from Mg hydroxide is large (see, FIGS. 1B and 2B).

Types of oxides and hydroxides in the hot-dip plating layer can be determined by analyzing the heat absorbing/radiating steel sheet by X-ray diffraction. FIGS. 3A and 3B show examples thereof. FIG. 3A illustrates an X-ray diffraction chart of a hot-dip plating layer in plated steel sheet 3 in the Examples, and FIG. 3B illustrates an X-ray diffraction chart of a hot-dip plating layer in heat absorbing/radiating steel sheet 3 in the Examples. In FIGS. 3A and 3B, "●," "▼," "▲," "○," "Δ" and "∇" represent Zn₂Mg, ZnO, Zn(OH)₂, Zn, Al and Fe, respectively.

From the diffraction intensities before and after the water vapor treatment, large peak intensities of Zn, Zn₂Mg and Al can be recognized before the water vapor treatment (in plated steel sheet 3). After the water vapor treatment (in heat absorbing/radiating steel sheet 3), however, those peak intensities decrease, and alternatively, peak intensities of ZnO and Zn(OH)₂ increase. From the change in those peak intensities, it is confirmed that the water vapor treatment generates oxides and hydroxides in the hot-dip plating layer.

The oxides and the like of Al and Mg are more likely to have broad peaks which are difficult to determine. In such cases, though, the determination can still be made by the above TOF-SIMS or ESCA. The oxides and hydroxides of Al and Mg can also be simply determined from distribution of each metal component and oxygen in a cross section of the absorbing/radiating steel sheet obtained by element mapping on the cross section using, for example, an electron probe micro analyzer (EPMA).

Whether the oxides and hydroxides have lattice defects or not can be determined by the presence of peaks in an electron spin resonance (ESR) spectrum. FIGS. 4A and 4B show examples thereof. FIG. 4A illustrates an ESR spectrum of a hot-dip plating layer in plated steel sheet 3 in the Examples, and FIG. 4B illustrates an ESR spectrum of a hot-dip plating layer in heat absorbing/radiating steel sheet 3 in the Examples. In FIGS. 4A and 4B, the abscissa represents the magnetic flux density (mT) and g-factor (symbol: g), and the ordinate represents the intensity.

From the comparison between ESR responses before and after the water vapor treatment, the ESR response can be recognized only after the water vapor treatment. It can be thus determined that the oxides and hydroxides generated by the water vapor treatment have lattice defects. The reason why lattice defects occur is not clear, but it can be deduced that the reaction with water vapor allows Zn, Al and Mg to be substituted with respective oxides or hydroxides, or positioned as interstitial atoms; or allows for generation of oxygen-depleted oxides or hydroxides of Zn, Al and Mg.

Whether the distribution is in a lamellar form or not can be determined by observation of a cross-sectional structure using an optical microscope or a scanning electron microscope. For example, upon observation of the cross-section, metal is observed as a paler portion, and the oxides and hydroxides as a grey or darker portion. FIG. 5 shows an example thereof. FIG. 5 is an optical microscope photograph of a cross-section in heat absorbing/radiating steel sheet 3 in the Examples.

The amount of the oxides and hydroxides can be determined by measuring the area of a corresponding portion by the observation of a cross-sectional structure using an optical microscope. Specifically, calculated is the area of a portion of the oxides and hydroxides in a field of view with 20 mm length in the cross section of the heat absorbing/radiating steel sheet. The portion of the oxides and hydroxides is grey or darker as described above, and the area of the portion can be calculated by, for example, image processing of the portion.

The area of the portion of the oxides and the like in the field of view with 20 mm length is 0.01 mm² or more. When the area is less than 0.01 mm², the amount of the oxides and hydroxides in the hot-dip plating layer may become unsatisfactory.

On the other hand, the upper limit of the area depends on the thickness of the hot-dip plating layer. It is thus necessary to determine the upper limit in accordance with the ratio to the thickness of the hot-dip plating layer. Specifically, the ratio of the area of the portion of the oxides and hydroxides to the area of the hot-dip plating layer portion in the cross section is 95% or less. When the area ratio is more than 95%, the portion of the oxide and the like may be dropped off from a heat absorbing/radiating steel sheet when the sheet is processed into a detailed or complex shape.

The area ratio can be obtained by, for example, calculating the area of a portion other than the portion of the oxides and hydroxides in the hot-dip plating layer in the cross section, obtaining the sum of the areas of the portion other than the portion of the oxides and the like and the portion of the oxides and hydroxides in the hot-dip plating layer (area of all the hot-dip plating layer in the cross section), and dividing the area of the portion of the oxides and hydroxides by the area of all the hot-dip plating layer and multiplying the same by 100.

The emissivity of the heat absorbing/radiating steel sheet is 0.4 or more. The heat absorbing/radiating properties of the heat absorbing/radiating steel sheet depend on the oxides and hydroxides, and are adjusted on the basis of the amounts thereof, for example. The emissivity can be measured using, for example, an emissivity meter (e.g., D and S AERD, Kyoto Electronics Manufacturing Co., LTD.). The emissivity can be appropriately determined in accordance with how the heat absorbing/radiating steel sheet is used, and, for example, when the emissivity is less than 0.4, the heat absorbing/radiating properties of the sheet as the material for a heat absorbing/radiating member may become unsatisfactory. For achieving higher heat absorbing/radiating properties, the emissivity is preferably 0.5 or more, and more preferably 0.6 or more.

Depending on the composition of the hot-dip plating layer, Al, Zn or Zn₂Mg may be precipitated as a primary crystal. In such a case, the primary crystal portion can be observed in a manner similar to the portion of the oxides and hydroxides in the cross-section observation, and the distribution thereof is different from that of a lamellar form. The primary crystal does not pose any substantial problem in the heat absorbing/radiating steel sheet, and rather becomes a path for promoting oxidization inside the hot-dip plating layer. As a result, production time for the heat absorbing/radiating steel sheet is more likely to become shorter.

The heat absorbing/radiating steel sheet may include a further configuration in a range where the effect of the present embodiment is obtained. In some cases, for example, a plated steel sheet is typically subjected to chemical conversion treatment for rust prevention, improving scratch resistance and/or improving sliding properties during processing, and thus has a chemical conversion film. The heat absorbing/radiating steel sheet may further include such a chemical conversion film. The chemical conversion film may be any one of an organic film, an inorganic film and an organic-inorganic composite film. Other than the chemical conversion film, the heat absorbing/radiating steel sheet may further include a clear coating. The film and coating may contain a chromate, or may be free from chromium and substantially contain no chromate. The film and coating may be formed either before or after the water vapor treatment of the hot-dip plated steel sheet.

In the case where the film or coating is formed before the water vapor treatment, the thickness of the film or coating is preferably 15 µm or less for satisfactorily bringing the hot-dip plating layer into contact with water vapor.

### [Production Method]

The heat absorbing/radiating steel sheet can be produced by, for example, providing a hot-dip plated steel sheet, and subjecting the sheet to water vapor treatment.

### (1) Providing of hot-dip plated steel sheet

The hot-dip plated steel sheet is produced by a hot-dip plating method using molten metal (alloy plating bath) with 1.0 to 22.0 mass% of Al, 1.3 to 10.0 mass% of Mg, and the balance substantially of Zn, for example. The hot-dip plating layer may be formed on one or both of the surfaces of the steel sheet.

The hot-dip plated steel sheet typically has Al-Zn-Zn₂Mg ternary eutectic structures in a lamellar form in the hot-dip plating layer thereof. Performing the above treatment allows the ternary eutectic structures to become structures which include oxides and the like having lattice defects, in a lamellar form. The oxides and hydroxides are distributed in a lamellar form in micro order, and thus, peeling off is less likely to occur after the processing of the hot-dip plated steel sheet.

When the hot-dip plated steel sheet has micro Al-Zn-Zn₂Mg ternary eutectic structures, the generation reaction of oxides and hydroxides having lattice defects by water vapor treatment described below proceeds quickly and is completed in a short time compared to other steel sheets. The reason for this is not clear, but the present inventors deduce that finely distributed Al, Zn and Zn₂Mg promoting oxidization of each metal component caused by a potential difference between the metal components may be the reason.

The alloy plating bath may further include other elements such as Si, Ti and/or B. The hot-dip plated steel sheet can be produced as a hot-dip Zn-Al-Mg alloy plated steel sheet by, for example, setting the temperature of the alloy plating bath to 400°C, cooling after the hot-dip plating to air cooling, and the average cooling rate to about 10°C/sec from the temperature of the alloy plating bath to the temperature at which the hot-dip plating layer solidifies.

### (2) Performing of water vapor treatment

The water vapor treatment brings the hot-dip plated steel sheet into contact with water vapor to convert a part of metal components in the hot-dip plating layer to oxides and hydroxides each having lattice defects. For the water vapor treatment, the oxygen amount in the environment is preferably adjusted to less than the typical oxygen concentration in the atmosphere, from the view point of allowing for uniform generating reaction of the oxide and/or the like. A conceivable reason is that a large amount of oxygen promotes the generation of oxides and hydroxides each without lattice defects. Therefore, the oxygen concentration in the environment for the water vapor treatment is preferably 13% or less. For preventing intrusion of oxygen into the environment, a closed container, or a semi-closed container which can maintain a raised internal pressure thereof is preferably used for the water vapor treatment. The semi-closed container is a container that can maintain its internal pressure higher than atmospheric pressure by providing water vapor. Specifically, to the container, water vapor is always or appropriately provided in an amount more than the amount that leaks.

The treatment temperature for the water vapor treatment is preferably 50 to 350°C. When the treatment temperature is less than 50°C, the reaction rate may become too low and the productivity may be lowered. When the treatment temperature is more than 350°C, the reaction rate may become too high, and alloying of the hot-dip plating layer and the steel sheet may progress during temperature rising, which leads to crumbling of structures in a lamellar form in the hot-dip plating layer. Consequently, production yield may become too low. Upon considering the reaction rate of the water vapor treatment, the treatment temperature is more preferably 105 to 200°C.

The relative humidity of the environment for the water vapor treatment is preferably 30 to 100%. When the relative humidity is less than 30%, the reaction rate may become too low and the productivity may be lowered.

The treatment time for the water vapor treatment is appropriately set in accordance with the treatment temperature, relative humidity, and/or a hot-dip plating layer composition. For example, the treatment time can be appropriately set within a range of 0.017 to 120 hours.

The shape of the hot-dip plated steel sheet to be subjected to the water vapor treatment can be determined in a range where the water vapor treatment can be satisfactorily performed. For example, the shape of the hot-dip plated steel sheet to be subjected to the water vapor treatment may be any one of the hot-dip plated steel sheets in a coil shape and a cut board shape and a processed product of the hot-dip plated steel sheet. When the hot-dip plated steel sheets are likely to be in contact with each other, a spacer is preferably disposed between the hot-dip plated steel sheets for satisfactorily bringing the hot-dip plating layers into contact with water vapor. Examples of the spacers include a nonwoven fabric, a meshed resin and a metal wire.

As obvious from the above description, the heat absorbing/radiating steel sheet can be produced by only using water vapor to a hot-dip plated steel sheet. Therefore, such a production method enables substantial reduction of impact on the environment compared to a method using VOC, and production of a steel sheet with excellent heat absorbing/radiating properties at low costs.

A heat absorbing/radiating member according to the present embodiment is composed of the heat absorbing/radiating steel sheet. The heat absorbing/radiating member may be composed of the heat absorbing/radiating steel sheet only, or may contain other configurations in addition to the heat absorbing/radiating steel sheet in a range where the member has the excellent heat absorbing/radiating properties derived from the heat absorbing/radiating steel sheet. Examples of the other configurations include an adhesive for bonding the heat absorbing/radiating steel sheet and a wax for welding. The adhesive is preferably heat transferable, such as an adhesive containing a heat transferable filler for enhancing the heat absorbing/radiating properties. Examples of the heat absorbing/radiating members include an object produced by at least one of processing, mechanical joining using a bolt or nut or by caulking, and welding of the heat absorbing/radiating steel sheet.

The heat absorbing/radiating member can be produced by processing the heat absorbing/radiating steel sheet, but also by subjecting a processed product of the hot-dip plated steel sheet to the water vapor treatment. The heat absorbing/radiating member produced by either production method has the excellent heat absorbing/radiating properties derived from the heat absorbing/radiating steel sheet.

As described above, the heat absorbing/radiating member has the excellent heat absorbing/radiating properties derived from the heat absorbing/radiating steel sheet. Therefore, the heat absorbing/radiating member is preferably a member that is required to at least absorb or radiate heat. For example, when the heat absorbing/radiating member is a housing for an electronic or electrical component, the housing satisfactorily absorbs heat generated from the electronic or electrical component inside, and satisfactorily radiates the heat outside the housing. Increase of the internal temperature of the housing is thus suppressed.

As obvious from the above description, the heat absorbing/radiating steel sheet includes a steel sheet and a hot-dip plating layer disposed on the surface of the steel sheet and has an emissivity of 0.4 or more, and the hot-dip plating layer contains Zn, 1.0 to 22.0 mass% of Al, 1.3 to 10.0 mass% of Mg, and oxides and hydroxides which have lattice defects and are distributed in a lamellar form. Therefore, the heat absorbing/radiating steel sheet does not suffer reduction of heat absorbing/radiating properties caused by processing, contains substantially no organic compound, and has excellent heat absorbing/radiating properties and processability.

The oxides and hydroxides of all of Zn, Al and Mg are more effective for enhancing the heat absorbing/radiating properties.

The heat absorbing/radiating member is composed of the heat absorbing/radiating steel sheet, and thus has excellent heat absorbing/radiating properties. The heat absorbing/radiating member has high freedom in its product design, and enables further downsizing compared to a conventional product.

### Examples

Hereinafter, Examples will be described; however, the scope of the present invention is not limited to those Examples.

### [Production of hot-dip plated steel sheets 1 to 21]

A plating layer (hot-dip plating layer) with a thickness in a range of 3 to 100 µm and made of molten metal containing Al, Mg and Zn was formed on a cold-rolled steel sheet (SPCC) with a sheet thickness of 1.2 mm to produce each of hot-dip plated steel sheets 1 to 20. The composition of each hot-dip plating layer was adjusted by changing the composition of the molten metal (concentrations of Zn, Al and Mg). The thickness of each hot-dip plating layer was adjusted by changing the deposition amount of the molten metal. Hot-dip plated steel sheet 21 free of Mg was also produced. In Table 1, the balance in the molten metal composition is substantially zinc. The compositions of the molten metal and the hot-dip plating layer produced therefrom are substantially the same.

The emissivity of each of hot-dip plated steel sheets 1 to 21 was measured. The emissivity was a value obtained by measuring each hot-dip plated steel sheet using an emissivity meter "D and S AERD" (manufactured by Kyoto Electronics Manufacturing Co., LTD.)

Table 1 shows the composition of the molten metal, the thickness (t_{D}) of the hot-dip plated steel sheet, and the emissivity (ε1) for each of hot-dip plated steel sheets 1 to 21.

**[Table 1]**

| Hot-Dip Plated Steel Sheet No. | Composition of Molten Metal mass% | | t_{D} (µm) | ε1 (-) |
|---|---|---|---|---|
| | Al | Mg | | |
| 1 | 1.0 | 3.0 | 15 | 0.26 |
| 2 | 6.0 | 3.0 | 15 | 0.25 |
| 3 | 11.0 | 3.0 | 15 | 0.18 |
| 4 | 22.0 | 3.0 | 15 | 0.15 |
| 5 | 6.0 | 1.3 | 15 | 0.20 |
| 6 | 6.0 | 10.0 | 15 | 0.32 |
| 7 | 1.8 | 1.9 | 15 | 0.28 |
| 8 | 3.7 | 3.1 | 15 | 0.29 |
| 9 | 2.3 | 2.2 | 15 | 0.19 |
| 10 | 4.0 | 3.3 | 15 | 0.31 |
| 11 | 6.0 | 3.0 | 18 | 0.25 |
| 12 | 6.0 | 3.0 | 3 | 0.24 |
| 13 | 6.0 | 3.0 | 6 | 0.24 |
| 14 | 6.0 | 3.0 | 10 | 0.17 |
| 15 | 6.0 | 3.0 | 30 | 0.27 |
| 16 | 6.0 | 3.0 | 100 | 0.34 |
| 17 | 0.5 | 3.0 | 15 | 0.30 |
| 18 | 30.0 | 3.0 | 15 | 0.16 |
| 19 | 6.0 | 1.1 | 15 | 0.20 |
| 20 | 6.0 | 15.0 | 15 | 0.31 |
| 21 | 0.2 | 0 | 15 | 0.10 |

### [Example 1]

Hot-dip plated steel sheet 1 was placed in high-temperature-pressure hygrothermal processing equipment (manufactured by Hisaka Works, LTD), and the hot-dip plating layer of hot-dip plated steel sheet 1 was brought into contact with water vapor under the treatment conditions of 120°C, 85% RH and 3% oxygen concentration as shown in Table 2 for 20 hours, thereby obtaining heat absorbing/radiating steel sheet 1.

### [Examples 2 to 23]

Hot-dip plated steel sheets 2 to 16 were used in place of hot-dip plated steel sheet 1, and the hot-dip plating layer of each hot-dip plated steel sheet was brought into contact with water vapor under the treatment conditions shown in Table 2, thereby obtaining one of heat absorbing/radiating steel sheets 2 to 23.

### [Comparative Examples 1 to 5]

Hot-dip plated steel sheets 17 to 21 were used in place of hot-dip plated steel sheet 1, and the hot-dip plating layers of hot-dip plated steel sheets were brought into contact with water vapor under the treatment conditions shown in Table 3, thereby obtaining respective heat absorbing/radiating steel sheets C1 to C5.

### [Comparative Examples 6 and 7]

Hot-dip plated steel sheets 4 and 16 were employed as heat absorbing/radiating steel sheets C6 and C7, respectively.

Table 2 shows the type of hot-dip plated steel sheet, treatment temperature (T1), relative humidity (Hr), oxygen concentration (Co) and treatment time (t1) for heat absorbing/radiating steel sheets 1 to 23. Table 3 shows the type of hot-dip plated steel sheet, treatment temperature (T1), relative humidity (Hr), oxygen concentration (Co) and treatment time (t1) for heat absorbing/radiating steel sheets C1 to C7.

Each of heat absorbing/radiating steel sheets 1 to 23 includes the oxides and the hydroxides distributed in a lamellar form as shown in FIG. 5.

**[Table 2]**

| Example No. | Heat Absorbing/Radiating Steel Sheet No. | Hot-Dip Plated Steel Sheet No. | Treatment Conditions | | | |
|---|---|---|---|---|---|---|
| | | | T1 (°C) | Hr (%) | Co (%) | t1 (Time) |
| 1 | 1 | 1 | 120 | 85 | 3.0 | 20 |
| 2 | 2 | 2 | 120 | 85 | 3.0 | 20 |
| 3 | 3 | 3 | 120 | 85 | 3.0 | 20 |
| 4 | 4 | 4 | 120 | 85 | 3.0 | 20 |
| 5 | 5 | 5 | 120 | 85 | 3.0 | 20 |
| 6 | 6 | 6 | 120 | 85 | 3.0 | 20 |
| 7 | 7 | 7 | 120 | 85 | 3.0 | 20 |
| 8 | 8 | 8 | 120 | 85 | 3.0 | 20 |
| 9 | 9 | 9 | 120 | 85 | 3.0 | 20 |
| 10 | 10 | 10 | 120 | 85 | 3.0 | 20 |
| 11 | 11 | 11 | 105 | 98 | 0.4 | 20 |
| 12 | 12 | 11 | 105 | 35 | 13.0 | 115 |
| 13 | 13 | 11 | 130 | 95 | 1.0 | 8 |
| 14 | 14 | 11 | 145 | 85 | 3.0 | 8 |
| 15 | 15 | 11 | 190 | 70 | 6.0 | 1 |
| 16 | 16 | 11 | 210 | 90 | 2.0 | 0.5 |
| 17 | 17 | 11 | 260 | 100 | 0.05 | 0.2 |
| 18 | 18 | 11 | 340 | 100 | 0.05 | 0.1 |
| 19 | 19 | 12 | 120 | 85 | 3.0 | 20 |
| 20 | 20 | 13 | 120 | 85 | 3.0 | 20 |
| 21 | 21 | 14 | 120 | 85 | 3.0 | 20 |
| 22 | 22 | 15 | 120 | 85 | 3.0 | 20 |
| 23 | 23 | 16 | 120 | 85 | 3.0 | 20 |

**[Table 3]**

| Comparative Example No. | Heat Absorbing/Radiating Steel Sheet No. | Hot-Dip Plated Steel Sheet No. | Treatment Conditions | | | |
|---|---|---|---|---|---|---|
| | | | T1 (°C) | Hr (%) | Co (%) | t1 (Time) |
| 1 | C1 | 17 | 120 | 85 | 3.0 | 20 |
| 2 | C2 | 18 | 120 | 85 | 3.0 | 20 |
| 3 | C3 | 19 | 120 | 85 | 3.0 | 20 |
| 4 | C4 | 20 | 120 | 85 | 3.0 | 20 |
| 5 | C5 | 21 | 120 | 85 | 3.0 | 20 |
| 6 | C6 | 4 | - | - | - | - |
| 7 | C7 | 16 | - | - | - | - |

### (1) Amount of oxides

A cross section of a part with 20 mm length in each of heat absorbing/radiating steel sheets 1 to 23 and C1 to C7 was observed using an optical microscope, thereby calculating the area of oxides in the cross section. A heat absorbing/radiating steel sheet with the area of 0.01 mm² or more was rated as "A," and more than 0.00 mm² and less than 0.01 mm² as "B," and heat absorbing/radiating steel sheet with no oxide being observed (i.e., 0.00 mm²) using optical microscope was rated as "C."

The area (A0) of all the hot-dip plating layer including a portion(s) of oxides in the cross section was further obtained to calculate the ratio (R_{A}) of the area (A1) of the oxides to the area A0 (i.e., R_{A} = (A1/A0) × 100 (%)). A heat absorbing/radiating steel sheet with the ratio of 95% or less was rated as "A," more than 95% as "B," and 0% as "C."

### (2) Heat absorbing/radiating properties

The emissivity (ε2) of each of heat absorbing/radiating steel sheets 1 to 23 and C1 to C7 was measured in the same manner as described above. A heat absorbing/radiating steel sheet with the emissivity ε2 of 0.5 or more was rated as "A," 0.4 or more and less than 0.5 as "B," and less than 0.4 as "C."

Each of heat absorbing/radiating steel sheets 1 to 23 and C1 to C7 was disposed on the top surface of an apparatus illustrated in FIGS. 6A and 6B, the temperature outside the apparatus was maintained at 25°C, and the temperature of a heater inside the apparatus was increased to 150°C, and after 2 hours, followed by measurement of the internal temperature (T2) of the apparatus using a thermocouple disposed inside the apparatus. A heat absorbing/radiating steel sheet with the measured temperature T2 of 38.0°C or less was rated as "A," more than 38.0°C and 38.5°C or less as "B," and more than 38.5°C as "C."

The apparatus illustrated in FIGS. 6A and 6B includes open housing 42 made of vinyl chloride, flat heater 43 disposed at the bottom of housing 42, thermocouple 44 for detecting the internal temperature of housing 42, which is disposed close to the upper opening of housing 42. Sample plate 41 of the heat absorbing/radiating steel sheet is disposed so as to cover the upper opening of housing 42. The walls and the bottom plate of housing 42 are covered with expanded polystyrene 45 having about 50 mm thickness to prevent heat radiation. The inside of housing 42 was heated with flat heater 43, and the internal temperature of housing 42 after heating was measured with thermocouple 44, thereby determining heat absorbing/radiating properties of each of heat absorbing/radiating steel sheets 1 to 23 and C1 to C7 based on the internal temperature, namely the measured value T2, and the above criteria.

### (3) Corrosion resistance

The corrosion resistance of each of heat absorbing/radiating steel sheets 1 to 23 and C1 to C7 was evaluated. For the evaluation of the corrosion resistance, a sample piece (150 mm long and 70 mm wide) was cut out from each of heat absorbing/radiating steel sheets 1 to 23 and C1 to C7, and the end faces thereof were sealed. Subsequently, the sample piece was subjected to repeated cycles each including a salt water spraying step, a drying step, and a moistening step (8 hours/cycle) to count the number of the cycles (Cy) until the ratio of red-rusted area reached 5%. In the salt water spraying step, 5% NaCl aqueous solution having a temperature of 35°C was sprayed to the sample piece for 2 hours. In the drying step, the sample piece was left standing for 4 hours in an environment at an atmospheric temperature of 60°C and a relative humidity of 30%. In the moistening step, the sample piece was left standing for 2 hours in an environment at an atmospheric temperature of 50°C and a relative humidity of 95%. A heat absorbing/radiating steel sheet requiring more than 120 cycles for the ratio of red-rusted area to reach 5% was rated as "A," more than 70 cycles and 120 cycles or less as "B," and 70 cycles or less as "C." A heat absorbing/radiating steel sheet which required more than 70 cycles was found qualified.

### (4) Processability

The processability of each of heat absorbing/radiating steel sheets 1 to 23 and C1 to C7 was evaluated. The processability was evaluated by the following procedure. Each of heat absorbing/radiating steel sheets 1 to 23 and C1 to C7 was punched to produce a circular sample plate having a diameter of 100 mm, and the weight thereof was measured. The measured sample plate was subjected to application of machining oil, subsequently to cylindrical drawing with the die diameter of 50 mm, the die shoulder R of 4 mm and the height of 25 mm, and to alkaline degreasing thereafter. The weight of the obtained processed product was measured. The weight after the processing was subtracted from the original weight to obtain the value ΔW, and the value ΔW was divided by 0.00785 m² (i.e., surface area of the sample plate), thereby obtaining the peeling amount (Ws) of the plating layer (including an oxide layer) per unit area. A sample plate with the peeling amount of 0.02 g/m² or less was rated as "A," more than 0.02 g/m² and 0.05 g/m² or less as "B," and more than 0.05 g/m² as "C." A sample plate with a value of 0.05 g/m² or less was found qualified.

Table 4 shows, for heat absorbing/radiating steel sheets 1 to 10, the area of oxides A1, the ratio of the area R_{A}, the emissivity ε2, the internal temperature T2 of the apparatus, the number of cycles Cy and the peeling amount Ws, and the evaluation results thereof. Table 5 shows, for heat absorbing/radiating steel sheets 11 to 23, the area of oxides A1, the ratio of the area R_{A}, the emissivity ε2, the internal temperature T2 of the apparatus, the number of cycles Cy and the peeling amount Ws, and the evaluation results thereof. Table 6 shows, for heat absorbing/radiating steel sheets C1 to C7, the area of oxides A1, the ratio of the area R_{A}, the emissivity ε2, the internal temperature T2 of the apparatus, the number of cycles Cy and the peeling amount Ws, and the evaluation results thereof.

**[Table 4]**

| Example No. | Heat Absorbing/Radiating Steel Sheet No. | Amount of Oxide | | | | Heat Absorbing/Radiating Properties | | | | Corrosion Resistance | | Processability | |
|---|---|---|---|---|---|---|---|---|---|---|---|---|---|
| | | Area | | Area Ratio | | Emissivity | | Temperature | | Cy (-) | Rate | Ws (g/m²) | Rate |
| | | A1 (mm²) | Rate | R_{A} (%) | Rate | ε2 (-) | Rate | T2 (°C) | Rate | | | | |
| 1 | 1 | 0.03 | A | 10 | A | 0.58 | A | 37.8 | A | 110 | B | 0.01> | A |
| 2 | 2 | 0.05 | A | 17 | A | 0.54 | A | 38.0 | A | 120< | A | 0.01> | A |
| 3 | 3 | 0.11 | A | 37 | A | 0.61 | A | 37.7 | A | 120< | A | 0.02 | A |
| 4 | 4 | 0.08 | A | 27 | A | 0.62 | A | 37.6 | A | 120< | A | 0.01 | A |
| 5 | 5 | 0.02 | A | 7 | A | 0.58 | A | 37.8 | A | 85 | B | 0.01> | A |
| 6 | 6 | 0.18 | A | 60 | A | 0.54 | A | 38.0 | A | 120< | A | 0.02 | A |
| 7 | 7 | 0.03 | A | 10 | A | 0.51 | A | 38.1 | B | 90 | B | 0.01> | A |
| 8 | 8 | 0.04 | A | 13 | A | 0.53 | A | 38.1 | B | 120< | A | 0.01> | A |
| 9 | 9 | 0.03 | A | 10 | A | 0.57 | A | 37.8 | A | 90 | B | 0.01> | A |
| 10 | 10 | 0.05 | A | 17 | A | 0.63 | A | 37.6 | A | 120< | A | 0.01> | A |

**[Table 5]**

| Example No. | Heat Absorbing/Radiating Steel Sheet No. | Amount of Oxide | | | | Heat Absorbing/Radiating Properties | | | | Corrosion Resistance | | Processability | |
|---|---|---|---|---|---|---|---|---|---|---|---|---|---|
| | | Area | | Area Ratio | | Emissivity | | Temperature | | Cy (-) | Rate | Ws (g/m²) | Rate |
| | | A1 (mm²) | Rate | R_{A} (%) | Rate | ε2 (-) | Rate | T2 (°C) | Rate | | | | |
| 11 | 11 | 0.05 | A | 14 | A | 0.45 | B | 38.3 | B | 120< | A | 0.01> | A |
| 12 | 12 | 0.07 | A | 19 | A | 0.42 | B | 38.3 | B | 120< | A | 0.01 | A |
| 13 | 13 | 0.09 | A | 25 | A | 0.48 | B | 38.2 | B | 120< | A | 0.01 | A |
| 14 | 14 | 0.15 | A | 42 | A | 0.62 | A | 37.6 | A | 120< | A | 0.02 | A |
| 15 | 15 | 0.12 | A | 33 | A | 0.68 | A | 37.4 | A | 120< | A | 0.02 | A |
| 16 | 16 | 0.14 | A | 39 | A | 0.63 | A | 37.6 | A | 120< | A | 0.01 | A |
| 17 | 17 | 0.16 | A | 44 | A | 0.59 | A | 37.7 | A | 120< | A | 0.02 | A |
| 18 | 18 | 0.20 | A | 56 | A | 0.67 | A | 37.4 | A | 120< | A | 0.03 | B |
| 19 | 19 | 0.04 | A | 67 | A | 0.58 | A | 37.8 | A | 73 | B | 0.01> | A |
| 20 | 20 | 0.04 | A | 33 | A | 0.55 | A | 37.9 | A | 120< | A | 0.01> | A |
| 21 | 21 | 0.05 | A | 25 | A | 0.59 | A | 37.7 | A | 120< | A | 0.01> | A |
| 22 | 22 | 0.04 | A | 7 | A | 0.57 | A | 37.8 | A | 120< | A | 0.01> | A |
| 23 | 23 | 0.05 | A | 3 | A | 0.67 | A | 37.4 | A | 120< | A | 0.01> | A |

**[Table 6]**

| Comparative Example No. | Heat Absorbing/Radiating Steel Sheet No. | Amount of Oxide | | | | Heat Absorbing/Radiating Properties | | | | Corrosion Resistance | | Processability | |
|---|---|---|---|---|---|---|---|---|---|---|---|---|---|
| | | Area | | Area Ratio | | Emissivity | | Temperature | | Cy (-) | Rate | Ws (g/m²) | Rate |
| | | A1 (mm²) | Rate | R_{A} (%) | Rate | ε2 (-) | Rate | T2 (°C) | Rate | | | | |
| 1 | C1 | 0.04 | A | 13 | A | 0.51 | A | 38.1 | B | 68 | C | 0.01> | A |
| 2 | C2 | 0.10 | A | 33 | A | 0.56 | A | 37.9 | A | 120< | A | 0.10 | C |
| 3 | C3 | 0.05 | A | 17 | A | 0.55 | A | 37.9 | A | 48 | C | 0.01> | A |
| 4 | C4 | 0.11 | A | 37 | A | 0.56 | A | 37.9 | A | 120< | A | 0.15 | C |
| 5 | C5 | 0.04 | A | 13 | A | 0.47 | B | 38.2 | B | 15 | C | 0.07 | C |
| 6 | C6 | 0.00 | C | 0 | C | 0.15 | C | 39.6 | C | 120< | A | 0.01> | A |
| 7 | C7 | 0.00 | C | 0 | C | 0.34 | C | 38.7 | C | 120< | A | 0.01> | A |

As shown in Tables 4 and 5, each of heat absorbing/radiating steel sheets 1 to 23 has a satisfactory and suitable amount of oxides in the plating layer thereof, as well as satisfactory heat absorbing/radiating properties, corrosion resistance and processability.

Each of heat absorbing/radiating steel sheets C1 to C7, on the other hand, is unsatisfactory in at least one of the heat absorbing/radiating properties, corrosion resistance and processability, as shown in Table 6.

For example, heat absorbing/radiating steel sheets C1, C3 and C5 are unsatisfactory in the corrosion resistance. A conceivable reason is that the Al and/or Mg content in the hot-dip plating layer of the sheet is outside a proper range.

In particular, heat absorbing/radiating steel sheet C5 is unsatisfactory also in the processability. The reason for this can be considered as follows. Since both Al and Mg contents in the hot-dip plating layer were outside proper ranges, oxides and/or hydroxides were almost uniformly dispersed in the hot-dip plating layer, and failed to be distributed in a lamellar form. In the hot-dip plating layer of heat absorbing/radiating steel sheet C5 after the water vapor treatment, oxidization progressed from the surface layer in the depth direction, and as a result, a two-layered structure was formed, in which oxides and the like were present only in the surface layer, and only unoxidized molten metal is present in the bottom layer. The brittle oxide layers concentrating in the surface layer of the hot-dip plating layer caused reduction of processability during cylindrical drawing of the heat absorbing/radiating steel sheet.

Heat absorbing/radiating steel sheets C2 and C4 had no beautiful plating, and suffered substantial reduction of processability. A conceivable reason is that oxides (dross) are generated in a large amount on the surface of a plating bath (molten metal) during the production of the hot-dip plated steel sheet, and the dross adhered on the surface of the hot-dip plating layer.

Heat absorbing/radiating steel sheets C6 and C7 were not brought into contact with water vapor, and thus have the emissivity of less than 0.40 and unsatisfactory heat absorbing/radiating properties. Not bringing the hot-dip plating layer of the hot-dip plated steel sheet into contact with water vapor may be the reason.

Heat absorbing/radiating steel sheets 1 to 23 were found to be excellent in all of the heat absorbing/radiating properties, corrosion resistance and processability.

### Industrial Applicability

Heat absorbing/radiating steel sheets according to the present invention are excellent in both processability and heat absorbing/radiating properties. Therefore, the heat absorbing/radiating steel sheets are particularly advantageous as materials for members whose heat absorbing and heat radiating properties are both required, such as home electric appliances, products for automobiles, roofing materials for buildings, and exterior materials.

### Reference Signs List

- 41: Sample plate
- 42: Housing
- 43: Flat heater
- 44: Thermocouple
- 45: Expanded polystyrene

## Claims

1. Use of a plated steel sheet as a heat absorbing/radiating steel sheet, the plated steel sheet comprising a steel sheet and a hot-dip plating layer disposed on a surface of the steel sheet,
wherein the plated steel sheet has an emissivity of 0.4 or more,
the hot-dip plating layer contains zinc, 1.0 to 22.0 mass% of aluminum, 1.3 to 10.0 mass% of magnesium, and both oxides and hydroxides of all of zinc, aluminum and magnesium, the oxides and the hydroxides having a lattice defect and being distributed in a lamellar form,
an area of a portion of the oxides and the hydroxides in a field of view with 20 mm length in a cross section of the plated steel sheet is 0.01 mm² or more, and
a ratio of an area of a portion of the oxides and the hydroxides to an area of the hot-dip plating layer in the cross section is 95% or less.

## Patentansprüche

1. Verwendung eines beschichteten Stahlblechs als wärmeabsorbierendes/abstrahlendes Stahlblech, welches ein Stahlblech und eine auf dessen Oberfläche angeordnete Feuerverzinkungsschicht umfasst,
wobei das beschichtete Stahlblech einen Emissionsgrad von 0,4 oder mehr aufweist,
die Feuerbeschichtung Zink, welches zu 1,0 auf 22,0 Massenprozent Aluminium, 1,3 auf 10,0 Massenprozent Magnesium verteilt ist, sowie Aluminium-, Magnesium- und Zinkoxide und Hydroxide beinhaltet, wobei die Oxide und Hydroxide einen Gitterfehler aufweisen und in einer Lamellenform angeordnet sind,
die Fläche eines Teils der Oxide und der Hydroxide, fokussiert auf einen Querschnitt von 20 mm Länge des beschichteten Stahlblechs, 0,01 mm² oder mehr beträgt und
das Verhältnis der Oxide und Hydroxide, in einer Fläche eines Teils, zur Fläche der Feuerverzinkungsschicht in diesem Querschnitt 95% oder weniger beträgt.

## Revendications

1. Utilisation d'une tôle d'acier plaquée comme tôle d'acier thermo-absorbant/rayonnant, la tôle d'acier plaquée comprenant une tôle d'acier et une couche de placage par immersion à chaud disposée sur une surface de la tôle d'acier,
sachant que la tôle d'acier plaquée a une émissivité de 0,4 ou plus,
que la couche de placage par immersion à chaud présente du zinc, de 1,0 à 22,0 d'aluminium pour cent en masse, de 1,3 à 10,0 de magnésium pour cent en masse, ainsi que des oxydes et des hydroxydes de zinc, d'aluminium et de magnésium, les oxydes et les hydroxydes ayant un défaut du réseau et étant distribués sur forme lamellaire,
qu'une surface d'une partie des oxydes et des hydroxydes dans un champ de vision ayant 20 mm de longueur dans une section transversale de la tôle d'acier est de 0,01 mm² ou plus et
qu'un rapport entre la surface d'une partie des oxydes et des hydroxydes et la surface de la couche de placage par immersion à chaud dans une section transversale est de 95% ou moins.
